# EUROPÄISCHE PATENTSCHRIFT

(11) **EP 1 643 565 B1**
(45) Veröffentlichungstag und Bekanntmachung des Hinweises auf die Patenterteilung: **04.03.2020**
(21) Anmeldenummer: 05020595.4
(22) Anmeldetag: 21.09.2005
(51) Int. Cl.: H01L 31/101, H01L 31/0216, H01L 31/0304, H01L 31/0352, G01J 3/51

(54) **STRAHLUNGSDETEKTOR**
RADIATION DETECTOR
DÉTECTEUR DE RAYONNEMENT

(30) Priorität: 30.09.2004 DE 102004047645; 11.01.2005 DE 102005001280
(43) Veröffentlichungstag der Anmeldung: 05.04.2006
(73) Patentinhaber: OSRAM Opto Semiconductors GmbH, 93055 Regensburg (DE)
(72) Erfinder: Jaeger, Arndt, 93051 Regensburg (DE); Stauss, Peter, 93186 Pettendorf (DE)
(74) Vertreter: Epping - Hermann - Fischer

(56) Entgegenhaltungen:
- WO-A1-00/77861
- JP-A- S63 170 978
- US-A- 4 581 625
- US-A- 4 677 289
- US-A- 5 689 123
- US-A1- 2002 008 191
- US-A1- 2004 178 463
- C. Pelosi ET AL: "In-depth analysis of the interfaces in InGaP/GaAs heterosystems", The European Physical Journal Applied Physics, vol. 27, no. 1-3, 1 July 2004 (2004-07-01) , pages 379-383, XP055211620, ISSN: 1286-0042, DOI: 10.1051/epjap:2004143
- J.G. Cederberg ET AL: "Oxygen-related Defects in In0.5(AlxGa1-x)0.5P Grown by MOVPE", Infrared applications of semiconductors II : symposium held December 1 - 4, 1997, Boston, Massachusetts, U.S.A. ; [Symposium F of the 1997 MRS Fall Meeting], vol. 484, 1 January 1998 (1998-01-01), pages 611-615, XP055211640, DOI: http://dx.doi.org/10.1557/PROC-484-611

## Beschreibung

Die Erfindung betrifft einen Strahlungsdetektor.

Zur Strahlungsdetektion in verschiedenen Wellenlängenbereichen wird oftmals ein Strahlungsdetektor mit einer Mehrzahl von nebeneinander angeordneten Si-Photodiodenchips eingesetzt. Über den einzelnen Si-Photodiodenchips zugeordnete externe Filter wird die spektrale Empfindlichkeitsverteilung des jeweiligen Si-Photodiodenchips an den gewünschten Wellenlängenbereich angepasst. Aufgrund der Mehrzahl von Photodiodenchips weisen derartige Strahlungsdetektoren in der Regel einen hohen Platzbedarf auf. Ein derartiger Strahlungsdetektor mit einer Mehrzahl beabstandet nebeneinander angeordneter Si-Photodiodenelemente, deren jeweilige Empfindlichkeit über dielektrische Filter an verschiedene Wellenlängenbereiche angepasst ist, ist aus dem vorläufigen Datenblatt zum Bauteil "MTCSiCT" der Firma Laser Components bekannt. Das Bauteil ist jedoch aufgrund der aufwendigen dielektrischen Filterung vergleichsweise kostenintensiv.

In der Druckschrift US 4,677,289 ist ein Farbsensor mit mehreren photovoltaischen Zellen mit unterschiedlichen Empfindlichkeitswellenlängenbereichen beschrieben.

Die Druckschrift US 2002/0008191 A1 betrifft eine Mehrfarben-Detektormatrix.

In der Druckschrift US 4,581,625 ist eine zweidimensionale Matrix von gestapelten photovoltaischen Bauelementen aus amorphen Silizium angegeben.

Die Druckschrift JP S63 170978 A betrifft einen Photodetektor, bei dem mehr als drei optische Absorptionsschichten mit unterschiedlichen maximalen Detektionswellenlängen vorgesehen sind, wobei jede optische Absorptionsschicht mit einer Filterschicht versehen ist.

Ein gattungsgemäßer Strahlungsdetektor, der auf dem III-V-Halbleitermaterialsystem AlₓGa₁₋ₓAs basiert, mit drei übereinander angeordneten Detektorelementen für drei getrennte Wellenlängenbereiche, von 7 µm bis 8 µm, von 10,5 µm bis 11,5 µm und von 14 µm bis 15 µm, im fernen Infrarot ist aus "Electronics Review, Volume 16, No. 3, pp. 18 - 19" bekannt.

Eine Aufgabe der vorliegenden Erfindung ist es, einen effizienten, kompakten Strahlungsdetektor zur Detektion im sichtbaren Spektralbereich anzugeben, der einen geringen Platzbedarf aufweist sowie vereinfacht und kostengünstig herstellbar ist.

Diese Aufgabe wird durch einen Strahlungsdetektor mit den Merkmalen des Patentanspruchs 1 gelöst. Vorteilhafte Weiterbildungen und Ausgestaltungen der Erfindung sind Gegenstand der abhängigen Ansprüche.

Ein erfindungsgemäßer Strahlungsdetektor umfasst eine Mehrzahl von Detektorelementen, die jeweils einen zum Strahlungsempfang und zur Signalerzeugung vorgesehenen aktiven Bereich aufweisen, wobei die Detektorelemente monolithisch in einen Halbleiterkörper des Strahlungsdetektors integriert sind, ein in einem ersten Detektorelement erzeugtes Signal getrennt von einem in einem zweiten Detektorelement erzeugten Signal abgreifbar ist, der Halbleiterkörper eine Strahlungseintrittsseite aufweist und das erste Detektorelement für sichtbare Strahlung teilweise durchlässig ist und sichtbare Strahlung, die durch das erste Detektorelement hindurchtritt, in dem zweiten Detektorelement ein Signal erzeugt.

Monolithische Integration einer Mehrzahl von Detektorelementen in einen Halbleiterkörper erleichtert eine vorteilhaft kostengünstige Herstellung bei zugleich platzsparender Ausbildung des Strahlungsdetektors. Bevorzugt ist der Halbleiterkörper epitaktisch auf einem Epitaxiesubstrat gewachsen. Die Detektorelemente sind weiterhin bevorzugt vertikal zu einer lateralen Haupterstreckungsrichtung des Halbleiterkörpers übereinander im Halbleiterkörper angeordnet.

Ferner ist der Strahlungsdetektor aufgrund der Mehrzahl monolithisch im Halbleiterkörper integrierter Detektorelemente, deren Signale unabhängig voneinander abgegriffen werden können, mit Vorteil zur Strahlungsdetektion in verschiedenen Wellenlängenbereichen, insbesondere im sichtbaren Spektralbereich, geeignet. Auf eine Mehrzahl von Si-Photodiodenchips, wie bei herkömmlichen Strahlungsdetektoren, kann zu diesem Zwecke verzichtet werden. Ein Detektorelement kann insbesondere auch als Einzeldetektor betrieben werden.

Weiterhin ist einem Detektorelement, bevorzugt ist den Detektorelementen jeweils, ein, insbesondere zusammenhängender, Wellenlängenbereich zugeordnet, in dem dieses Detektorelement empfindlich ist, d.h. ein signifikantes Signal erzeugt. Besonders bevorzugt sind verschiedenen Detektorelementen verschiedene Wellenlängenbereiche zugeordnet.

In einer bevorzugten Ausgestaltung der Erfindung weist wenigstens ein Detektorelement eine, insbesondere zusammenhängende, spektrale Empfindlichkeitsverteilung mit einem Maximum - einem lokalen oder globalen Maximum - bei einer vorgegebenen Maximalwellenlänge auf, die zweckmäßigerweise im dem Detektorelement zugeordneten Wellenlängenbereich liegt. Bevorzugt sind die Maximalwellenlängen der spektralen Empfindlichkeitsverteilungen mindestens zweier, besonders bevorzugt aller Detektorelemente, verschieden.

Für die spektrale Empfindlichkeitsverteilung eines Detektorelements ist hierbei die Abhängigkeit des im aktiven Bereich dieses Detektorelements erzeugten Signals (des Photostroms oder davon abgeleiteten Größen) von der Wellenlänge der auf das Detektorelement einfallenden Strahlung maßgeblich.

Von der Strahlungseintrittsseite in den Halbleiterkörper eintretende Strahlung trifft auf ein Detektorelement. Enthält die einfallende Strahlung einen spektralen Anteil, insbesondere im sichtbaren Spektralbereich, für den das Detektorelement empfindlich ist, so wird ein entsprechender Anteil der Strahlungsleistung im aktiven Bereich des Detektorelements absorbiert. Die in der Folge im aktiven Bereich erzeugten Elektron-Loch-Paare tragen zum Signal des Detektorelements bei. Der Anteil an im aktiven Bereich absorbierter Strahlungsleistung kann durch die Dicke, und der Empfindlichkeitsbereich des Detektorelements durch die Bandlücke einer im aktiven Bereich angeordneten Funktionsschicht gezielt beeinflusst werden. Zweckmäßigerweise entspricht die Bandlücke der Funktionsschicht der vorgegebenen Maximalwellenlänge der spektralen Empfindlichkeitsverteilung des Detektorelements. Eine Vergrößerung der Dicke der Funktionsschicht resultiert in der Regel in einer Erhöhung der in ihr absorbierten Strahlungsleistung, was wiederum in der Regel höhere Signale liefert.

Der durch das Detektorelement transmittierte Anteil der einfallenden Strahlung kann in einem oder mehreren weiteren, obigem Detektorelement von der Strahlungseintrittsseite aus gesehen nachgeordneten Detektorelement(en) ein Signal erzeugen. Über eine gezielte Abstimmung der Dicken der aktiven Bereiche bzw. der Funktionsschichten der Detektorelemente aufeinander können die Werte der Maxima, insbesondere der globalen Maxima, der spektralen Empfindlichkeitsverteilungen verschiedener Detektorelemente aneinander angepasst werden. Der Vergleich der in den verschiedenen Detektorelementen erzeugten Signale wird so erleichtert.

Sind verschiedene Detektorelemente verschiedenen Wellenlängenbereichen bzw. Maximalwellenlängen zugeordnet, so kann über die im jeweiligen Detektorelement erzeugten und getrennt messbaren Signale auf vorteilhaft einfache Weise Aufschluss über spektrale Anteile, insbesondere im sichtbaren Spektralbereich, in einer auf den Strahlungsdetektor einfallenden Strahlung erhalten werden.

Um eine Zuordnung der Signale zu dem aktiven Bereich des jeweiligen Detektorelements, in dem sie erzeugt wurden, zu erleichtern, sind die aktiven Bereiche im Halbleiterkörper benachbart angeordneter Detektorelemente bevorzugt voneinander beabstandet. Besonders bevorzugt ist zwischen zwei benachbarten aktiven Bereichen ein signalarmer Bereich ausgebildet, in dem eventuell durch Strahlungsabsorption erzeugte Elektron-Loch-Paare im wesentlichen sofort rekombinieren und nicht oder nur in sehr geringem Maße zu dem zu messenden Signal beitragen. Zum Signal eines Detektorelements tragen mit Vorzug im wesentlichen nur im aktiven Bereich dieses Detektorelements erzeugte Elektron-Loch-Paare bei.

Ein für den ferninfraroten Spektralbereich ausgebildeter Detektor der eingangs erwähnten Art ist für den sichtbaren Spektralbereich, selbst abgesehen von der geringen Empfindlichkeit, ungeeignet, da auf diesen einfallende sichtbare spektrale Anteile im strahlungseintrittseitig angeordneten infraroten Detektorelement im wesentlichen vollständig absorbiert werden und dementsprechend in diesem Detektorelement nachgeordneten, weiteren Detektorelementen kein nennenswertes Signal erzeugt würde.

In einer weiteren bevorzugten Ausgestaltung der Erfindung ist der Strahlungsdetektor zur Detektion von Strahlung in einem vorgegebenen, vorzugsweise zusammenhängenden, Wellenlängenbereich ausgebildet. Besonders bevorzugt liegen die Maximalwellenlängen der Detektorelemente des Strahlungsdetektors in diesem vorgegebenen Wellenlängenbereich, wobei insbesondere auch bei einer beliebigen Wellenlänge im Bereich zwischen zwei benachbarten Maximalwellenlängen ein signifikantes Signal erzeugt wird.

In einer weiteren bevorzugten Ausgestaltung der Erfindung überlappen die spektralen Empfindlichkeitsverteilungen mindestens zweier Detektorelemente. Die Überdeckung eines breiten, zusammenhängenden Wellenlängenbereichs mittels einer Mehrzahl von Detektorelementen wird so erleichtert. Als breiter Wellenlängenbereich kann hierbei ein Wellenlängenbereich angesehen werden, der zumindest eine Breite aufweist, die größer ist als die Summe der spektralen Breiten (FWHM: Full Width at Half Maximum) der Empfindlichkeitsverteilungen der zur Überdeckung des Wellenlängenbereichs vorgesehenen Detektorelemente.

Es sei angemerkt, dass unter Überlapp ein Überlapp verstanden wird, der sich von einem eventuellen Untergrundrauschen abhebt. Ein Überlapp zweier Empfindlichkeitsverteilungen aufgrund asymptotisch auslaufender Flanken wird insbesondere nicht als Überlapp in obigem Sinne angesehen.

In einer vorteilhaften Weiterbildung der Erfindung überlappen Empfindlichkeitsverteilungen mit benachbarten Maximalwellenlängen, vorzugsweise nur mit den beidseitig nächstgelegenen Maximalwellenlängen, paarweise. Der vom Strahlungsdetektor abgedeckte Wellenlängenbereich kann so vorteilhaft vergrößert werden. Insbesondere kann ein unnötiger gemeinsamer Überlapp dreier Empfindlichkeitsverteilungen vermieden werden.

In einer weiteren bevorzugten Ausgestaltung der Erfindung nehmen die Maximalwellenlängen der spektralen Empfindlichkeitsverteilungen der Detektorelemente mit wachsender Entfernung der Detektorelemente von der Strahlungseintrittsseite zu. Ein seitens der Strahlungseintrittsseite angeordnetes Detektorelement weist somit mit Vorzug eine kurzwelligere Maximalwellenlänge auf, wohingegen ein diesem Detektorelement nachgeordnetes Detektorelement eine längerwellige Maximalwellenlänge aufweist. Energiereichere kurzwellige Strahlung wird somit eher näher an der Strahlungseintrittsseite absorbiert und erzeugt ein Signal in einem nahe der Strahlungseintrittsseite angeordneten Detektorelement. Der eventuell unerwünschte Einfluss von Absorption kurzwelliger Strahlungsanteile auf die Signale von Detektorelementen, die für längerwellige Strahlung ausgebildet und dem für kurzwelligere Strahlung ausgebildeten Detektorelement von der Strahlungseintrittsseite aus gesehen nachgeordnet sind, kann so verringert werden.

In einer weiteren bevorzugten Ausgestaltung der Erfindung weist wenigstens ein aktiver Bereich, vorzugsweise weisen alle aktiven Bereiche, eine Einfach-Quantentopfstruktur oder eine Mehrfach-Quantentopfstruktur oder eine Heterostruktur, insbesondere eine Doppelheterostruktur, auf. Vorzugsweise sind alle aktiven Bereiche mittels einer gleichartigen Struktur gebildet. Derartige Strukturen zeichnen sich durch vorteilhaft hohe interne Quanteneffizienzen aus.

Die Bezeichnung Quantentopfstruktur umfasst im Rahmen der Anmeldung jegliche Struktur, bei der Ladungsträger durch Einschluss ("confinement") eine Quantisierung ihrer Energiezustände erfahren. Insbesondere beinhaltet die Bezeichnung Quantentopfstruktur keine Angabe über die Dimensionalität der Quantisierung. Sie umfasst somit u.a. Quantentröge, Quantendrähte und Quantenpunkte und jede Kombination dieser Strukturen.

Den Detektorelementen sind jeweils eine Kontaktschicht und eine Gegenkontaktschicht zugeordnet, über die ein im aktiven Bereich des Detektorelements erzeugtes Signal erfasst werden kann. Hierbei kann eine Mehrzahl von Kontakt- und/oder Gegenkontaktschichten monolithisch im Halbleiterkörper integriert sein.

Weiterhin ist die Kontaktschicht oder die Gegenkontaktschicht wenigstens eines Detektorelements zwischen dem Detektorelement und einem diesem benachbarten Detektorelement angeordnet. Eine Kontakt- und eine Gegenkontaktschicht weisen, falls ein Halbleitermaterial enthaltend, weiterhin bevorzugt unterschiedliche Leitungstypen (n- oder p-leitend) auf.

In einer weiteren bevorzugten Ausgestaltung der Erfindung weisen, vorzugsweise jeweils, zwei benachbarte Detektorelemente eine gemeinsame Kontaktschicht bzw. eine gemeinsame Gegenkontaktschicht auf, so dass auf das Ausbilden separater Kontaktschichten bzw. Gegenkontaktschichten für diese Detektorelemente mit Vorteil verzichtet werden kann. Weiterhin reduziert sich aufgrund der verringerten Schichtanzahl mit Vorteil der Platzbedarf eines derartigen Detektors.

In einer alternativen Ausgestaltung der Erfindung ist ein Kontaktschichtpaar - gebildet durch Kontaktschicht und Gegenkontaktschicht - eines Detektorelements von dem eines, insbesondere beliebigen, weiteren Detektorelements verschieden. Die Kontakt- bzw. Gegenkontaktschicht kann so für das jeweilige Detektorelement geeignet, je nach vorteilhaften Kontakteigenschaften, ausgebildet werden. Insbesondere können separate Kontaktschichtpaare für verschiedene Detektorelemente vorgesehen sein.

Einem Detektorelement ist in Richtung der Strahlungseintrittseite des Halbleiterkörpers eine Filterschichtstruktur mit mindestens einer Filterschicht nachgeordnet. Die Filterschichtstruktur ist monolithisch in den Halbleiterkörper integriert.

Die Filterschichtstruktur ist weiterhin bevorzugt zur Absorption von Wellenlängen in einem Wellenlängenbereich ausgebildet, der Wellenlängen kleiner der Maximalwellenlänge der spektralen Empfindlichkeitsverteilung des Detektorelements umfasst. Die in der Filterschichtstruktur absorbierte Strahlungsleistung wird durch eine Dicke, und der entsprechende Wellenlängenbereich der Absorption durch eine - direkte oder indirekte - Bandlücke der Filterschicht bestimmt. Die Bandlücke der Filterschicht ist bevorzugt größer als die Bandlücke der Funktionsschicht des aktiven Bereichs des Detektorelements. Gegebenenfalls kann die Filterschichtstruktur eine Mehrzahl von Filterschichten unterschiedlicher Bandlücken und/oder Dicken umfassen. Über die Filterschichtstruktur kann die kurzwellige Seite der spektralen Empfindlichkeitsverteilung, mit Wellenlängen kleiner der Maximalwellenlänge, gezielt geformt werden, da in der Filterschicht Strahlungsanteile absorbiert werden und im aktiven Bereich des Detektorelements für Wellenlängen im Absorptionsbereich der Filterschichtstruktur nur ein dementsprechend vermindertes Signal erzeugt wird.

In einer vorteilhaften Weiterbildung der Erfindung ist einer Mehrzahl von Detektorelementen, vorzugsweise allen, jeweils eine, insbesondere separate, Filterschichtstruktur der oben genannten Art zugeordnet. Filterschichtstrukturen für die jeweiligen Detektorelemente sind gegebenenfalls voneinander verschieden. Hierdurch können die kurzwelligen Seiten der Empfindlichkeitsverteilungen der Detektorelemente hinsichtlich ihres spektralen Verlaufs aneinander angepasst werden, wodurch der Vergleich in verschiedenen Detektorelementen erzeugter Signale erleichtert wird. Die einem Detektorelement zugeordnete Filterschichtstruktur ist weiterhin bevorzugt zwischen dem Detektorelement und einem weiteren, diesem strahlungseintrittsseitig nachgeordneten, insbesondere benachbarten, Detektorelement angeordnet.

Die Kontaktschicht bzw. die Gegenkontaktschicht wenigstens eines Detektorelements ist zugleich als Filterschicht, insbesondere einer diesem Detektorelement zugeordneten Filterschichtstruktur, ausgebildet.

In einer weiteren vorteilhaften Weiterbildung der Erfindung absorbiert die einem Detektorelement zugeordnete Filterschichtstruktur in einem Wellenlängenbereich, der Wellenlängen größer der Maximalwellenlänge eines weiteren Detektorelements umfasst. Das weitere Detektorelement ist dem Detektorelement vorzugsweise strahlungseintrittsseitig im Halbleiterkörper nachgeordnet und/oder weist eine verglichen mit der Maximalwellenlänge des Detektorelements kurzwelligere Maximalwellenlänge auf. Ein übergroßer Überlapp spektraler Empfindlichkeitsverteilungen der beiden Detektorelemente kann so gegebenenfalls auf einfache Weise verringert werden.

Insbesondere kann mit Vorteil auf raumgreifende und aufwendige externe Filter, Filter, die außerhalb des Halbleiterkörpers angeordnet sind, zur Anpassung der Empfindlichkeit des-Strahlungsdetektors verzichtet werden. Die einzelnen Detektorelemente können vielmehr mit einer monolithisch integrierten Filterschichtstruktur gemäß einer vorgegebenen Empfindlichkeitsverteilung gefertigt werden.

In einer weiteren bevorzugten Ausgestaltung der Erfindung enthält der Halbleiterkörper, insbesondere der aktive Bereich und/oder die Filterschichtstruktur wenigstens eines Detektorelements, mindestens ein III-V Halbleitermaterial, insbesondere ein Halbleitermaterial aus den Materialsystemen InₓGa_{y}Al_{1-x-y}P, InₓGa_{y}Al_{1-x-y}As oder InₓGa_{y}Al_{1-x-y}N, jeweils mit 0≤x≤1, 0≤y≤1 und x+y≤1, enthält. Mit besonderem Vorzug basiert der gesamte Halbleiterkörper auf III-V-Halbleitermaterialien. Derartige Materialien zeichnen sich durch hohe interne Quanteneffizienzen aus.

In einer weiteren bevorzugten Ausgestaltung der Erfindung ist der Strahlungsdetektor für den sichtbaren Spektralbereich ausgebildet. Bevorzugt ist hierbei eine Mehrzahl, besonders bevorzugt sind alle, der aktiven Bereiche zum Strahlungsempfang im sichtbaren Spektralbereich vorgesehen. Es hat sich gezeigt, dass ein Strahlungsdetektor für den sichtbaren Spektralbereich mittels dreier Detektorelemente besonders effizient realisiert werden kann. Die aktiven Bereiche basieren vorzugsweise auf dem Materialsystem InₓGa_{y}Al_{1-x-y}P, das sich durch hohe interne Quanteneffizienzen im sichtbaren Spektralbereich auszeichnet. Filterschichtstrukturen der jeweiligen Detektorelemente können auf dem Materialsystem InₓGa_{y}Al_{1-x-y}P oder InₓGa_{y}Al_{1-x-y}As basieren. Enthält der Halbleiterkörper, insbesondere eine Filterschichtstruktur, ein Material aus dem Untermaterialsystem AlₓGa₁₋ₓAs, so ist es aus Gründen der Gitteranpassung für die Herstellung des Halbleiterkörpers vorteilhaft, für die auf dem Materialsystem InₓGa_{y}Al_{1-x-y}P basierenden Schichten Materialien aus dem Untermaterialsystem In_{0,5}(Ga₁₋ₓAlₓ)_{0,5}P zu wählen. Die Bandlücke kann hierbei über den Al-Gehalt eingestellt werden.

Insgesamt kann ein Strahlungsdetektor realisiert werden, der einen zusammenhängenden Wellenlängenbereich der Länge 280 nm, etwa von 400 nm bis 680 nm, überdeckt. Besonders bevorzugt überdeckt der Strahlungsdetektor einen zusammenhängenden Wellenlängenbereich von 430 bis 650 nm.

In einer weiteren bevorzugten Ausgestaltung der Erfindung sind die Detektorelemente, insbesondere jeweils, zur Detektion verschiedenfarbiger Strahlungen ausgebildet. Beispielsweise umfasst der Strahlungsdetektor drei Detektorelemente, die zur Detektion von Strahlung im blauen, grünen beziehungsweise roten Spektralbereich ausgebildet sind.

In einer vorteilhaften Weiterbildung der Erfindung ist der Strahlungsdetektor zur Bestimmung von spektralen Farbanteilen in der vom Strahlungsdetektor zu empfangenden Strahlung ausgebildet. Durch Abgreifen der Signale an den verschiedenen Detektorelementen, die mit Vorzug verschiedenen Farben zugeordnet sind, kann Aufschluss über die spektralen Farbanteile in der auf den Strahlungsdetektor einfallenden Strahlung gewonnen werden.

In einer weiteren bevorzugten Ausgestaltung der Erfindung ist der Strahlungsdetektor zur Bestimmung des Farbeindrucks, etwa des Farborts und/oder der Farbtemperatur, der einfallenden Strahlung ausgebildet. Der Farbort wird üblicherweise durch die Farbkoordinaten (x und y) im CIE-Diagramm angegeben. Enthält die einfallende Strahlung beispielsweise in erhöhtem Maße blaue Anteile, so wird im zugeordneten Detektorelement ein dementsprechend hohes Signal erzeugt, während in den Detektorelementen für den roten und grünen Spektralbereich entsprechend geringe Signale erzeugt werden. Durch Vergleich der drei unabhängigen Signale kann demgemäß Aufschluss über den Farbort der einfallenden Strahlung gewonnen werden.

Weitere bevorzugte Ausgestaltungen, Vorteile und Zweckmäßigkeiten der Erfindung ergeben sich aus der Beschreibung der folgenden Ausführungsbeispiele in Verbindung mit den Figuren.

Es zeigen:
Figur 1 ein erstes Ausführungsbeispiel eines erfindungsgemäßen Strahlungsdetektors anhand einer schematischen Schnittansicht,
Figur 2 eine qualitative Darstellung der spektralen Empfindlichkeitsverteilung eines erfindungsgemäßen Strahlungsdetektors gemäß dem ersten Ausführungsbeispiel,
Figur 3 ein zweites Ausführungsbeispiel eines erfindungsgemäßen Strahlungsdetektors anhand einer schematischen Schnittansicht und
Figur 4 eine Simulation der spektralen Empfindlichkeitsverteilung des Strahlungsdetektors gemäß dem zweiten Ausführungsbeispiel.

Gleiche, gleichartige und gleichwirkende Elemente sind in den Figuren mit gleichen Bezugszeichen versehen.

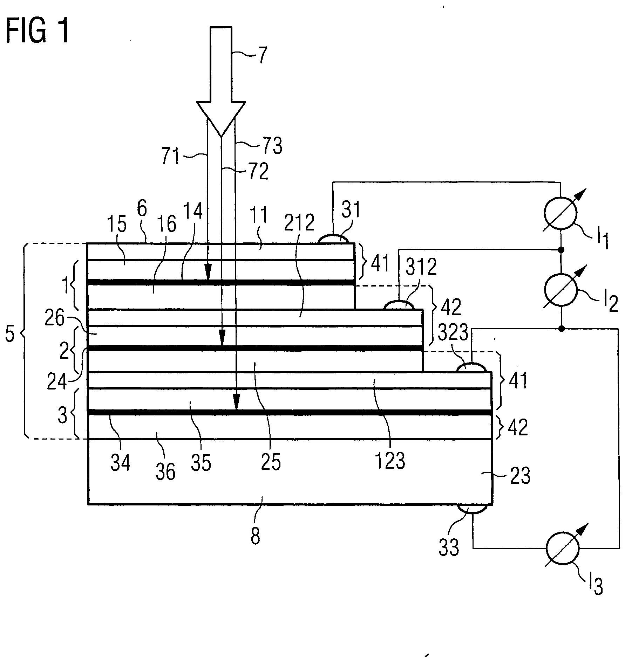

In Figur 1 ist ein Ausführungsbeispiel eines erfindungsgemäßen Strahlungsdetektors anhand einer Schnittansicht schematisch dargestellt.

Der Strahlungsdetektor weist in diesem Ausführungsbeispiel ein erstes Detektorelement 1 mit einem ersten aktiven Bereich 14, ein zweites Detektorelement 2 mit einem zweiten aktiven Bereich 24 und ein drittes Detektorelement 3 mit einem dritten aktiven Bereich 34 auf, die jeweils zum Strahlungsempfang und zur Signalerzeugung vorgesehen und monolithisch in einen gemeinsamen Halbleiterkörper 5 integriert sind. Der Halbleiterkörper ist hierfür epitaktisch auf einem geeigneten Epitaxiesubstrat gewachsen. Die Detektorelemente sind vertikal zu einer lateralen Haupterstreckungsrichtung der aktiven Bereiche übereinander angeordnet. Das erste Detektorelement 1 ist für sichtbare Strahlung teilweise durchlässig, so dass sichtbare Strahlung, die durch das erste Detektorelement hindurchtritt, im zweiten oder dritten Detektorelement ein Signal erzeugt.

Von einer Strahlungseintrittsseite 6 her auf den Halbleiterkörper 5 auftreffende Strahlung 7 wird im aktiven Bereich 14 des ersten Detektorelements 1 entsprechend einer Bandlücke einer Funktionsschicht des aktiven Bereichs teilweise absorbiert, falls die einfallende Strahlung spektrale Anteile im Bereich der Bandlücke der Funktionsschicht aufweist. Entsprechend werden im zweiten 2 und/oder dritten 3 Detektorelement Anteile aus der durch das erste Detektorelement transmittierten Strahlung absorbiert.

Die durch die Absorption in den voneinander beabstandeten aktiven Bereichen erzeugten Elektron-Loch-Paare liefern Signale, die an verschiedenen Detektorelementen gleichzeitig und getrennt voneinander abgegriffen werden können.

Die aktiven Bereiche 14, 24 bzw. 34 der Detektorelemente sind bevorzugt jeweils zwischen einer Barriereschicht 15, 25 bzw. 35 und einer Gegenbarriereschicht 16, 26 bzw. 36, die für verschiedene Detektorelemente bevorzugt gleiche Zusammensetzungen aufweisen, angeordnet. Barriere- und Gegenbarriereschicht eines Detektorelements weisen weiterhin bevorzugt unterschiedliche Leitungstypen (n-leitend oder p-leitend) auf und rufen jeweils eine Raumladungszone des Detektorelements hervor, in der der aktive Bereich des Detektorelements angeordnet ist. Mit Vorzug tragen im wesentlichen nur in der Raumladungszone eines Detektorelements generierte Elektron-Loch-Paare zum Signal dieses Detektorelements bei.

Der Halbleiterkörper 5 ist auf einem Träger 8 angeordnet, der den Halbleiterkörper mechanisch stabilisiert. Der Träger kann das Epitaxiesubstrat des Halbleiterkörpers 5 umfassen oder von diesem verschieden sein. Ist der Träger vom Epitaxiesubstrat verschieden, wird der Halbleiterkörper zweckmäßigerweise nach beendeter Epitaxie auf der dem Epitaxiesubstrat abgewandten Seite auf dem Träger befestigt. Nachfolgend kann das Epitaxiesubstrat entfernt werden. Gegebenenfalls kann auf die dem Epitaxiesubstrat abgewandten Seite des Halbleiterkörpers vor der Anordnung auf dem Träger noch eine, beispielsweise metallhaltige, Spiegelschicht auf den Träger aufgebracht werden. Ein derartiger Träger kann im Gegensatz zu einem Epitaxiesubstrat, das hohen Anforderungen, etwa bezüglich der Kristallstruktur genügen muss, vergleichsweise frei gewählt werden.

Ein derartiger Strahlungsdetektor kann kostengünstig, auf einfache Weise hergestellt werden und weist einen vorteilhaft geringen Platzbedarf auf.

Die Detektorelemente sind insbesondere als voneinander unabhängige Einzeldetektoren betreibbar, die zweckmäßigerweise zur Detektion von Strahlung in verschiedenen Wellenlängenbereichen ausgebildet sind. Die Detektorelemente sind übereinander in einem Halbleiterchip (Halbleiterkörper auf dem Träger) integriert.

Zur elektrischen Kontaktierung des Strahlungsdetektors ist jedem der Detektorelemente eine Kontaktschicht und eine Gegenkontaktschicht zugeordnet, über die das im Detektorelement erzeugte Signal getrennt von den übrigen Detektorelementen erfasst werden kann. Die Kontakt- und/oder die Gegenkontaktschicht ist(sind) vorzugsweise im Halbleiterkörper monolithisch integriert. Weiterhin weisen Kontakt- und Gegenkontaktschicht bevorzugt unterschiedliche Leitungstypen auf.

Im Ausführungsbeispiel gemäß Figur 1 sind dem ersten Detektorelement 1 eine erste Kontaktschicht 11 und eine erste Gegenkontaktschicht 212 zugeordnet, die im Halbleiterkörper monolithisch integriert sind und zwischen denen das Detektorelement 1 angeordnet ist.

Die erste Gegenkontaktschicht 212 ist mit Vorteil zugleich als Gegenkontaktschicht für das zweite Detektorelement 2 ausgebildet, das zwischen der ersten Gegenkontaktschicht 212 und der zweiten Kontaktschicht 123, welche ebenfalls monolithisch im Halbleiterkörper integriert ist, angeordnet ist. Das dritte Detektorelement 3 ist zwischen der zweiten Kontaktschicht 123 und einer zweiten Gegenkontaktschicht 23 angeordnet. Die zweite Gegenkontaktschicht 23 ist zweckmäßigerweise durch den Träger 8 gegeben. Die benachbarten Detektorelemente 1 und 2 bzw. zwei und drei weisen demnach eine gemeinsame Gegenkontaktschicht 212 bzw. eine gemeinsame Kontaktschicht 123 auf.

Zum Ausbilden gemeinsamer (Gegen)Kontaktschichten ist es zweckmäßig, dass die Leitungstypen im Halbleiterkörper in vertikaler Richtung an einem aktiven Bereich wechseln und/oder zwischen zwei benachbarten aktiven Bereichen gleich sind. Vorzugsweise sind Halbleiterbereiche 41 vom ersten Leitungstyp und Halbleiterbereiche 42 vom zweiten Leitungstyp. Dient der Träger 8 der Kontaktierung des Strahlungsdetektors und enthält ein Halbleitermaterial, so ist er zweckmäßigerweise entsprechend dem Leitungstyp des angrenzenden Halbleiterbereichs dotiert.

Über mit den jeweiligen Kontakt- beziehungsweise Gegenkontaktschichten verbundene Anschlüsse 31, 312, 323 und 33, beispielsweise jeweils ein Metall oder eine Legierung enthaltend, die mit den entsprechenden aktiven Bereichen über die Kontaktschichten beziehungsweise Gegenkontaktschichten elektrisch leitend verbunden sind, kann das in den aktiven Bereichen erzeugte Signal erfasst und weiter verarbeitet werden.

Ein im ersten aktiven Bereich 14 erzeugte Signal I₁ wird über die Anschlüsse 31 und 312, ein im zweiten aktiven Bereich 24 erzeugte Signal I₂ über die Anschlüsse 312 und 323 und ein im dritten aktiven Bereich 34 erzeugte Signal I₃ über die Anschlüsse 323 und 33 erfasst.

Die laterale Ausdehnung der Detektorelemente, insbesondere der aktiven Bereiche, nimmt bevorzugt in vertikaler Richtung von der Strahlungseintrittseite 6 aus gesehen zu. Die Anordnung der Anschlüsse auf den entsprechenden Kontaktbeziehungsweise Gegenkontaktschichten wird so erleichtert. Beispielsweise kann ein derartiger Verlauf durch eine treppenartige Struktur, wie in Figur 1 schematisch gezeigt, realisiert werden. Derartige Strukturen können aus einem unstrukturierten Halbleitergrundkörper beispielsweise mittels naßchemischem Ätzen oder selektivem Ätzen erzeugt werden.

Die Detektorelemente können gegebenenfalls auch mit separaten Kontakt- und Gegenkontaktschichten versehen werden, wobei die Höhe des Strahlungsdetektors dementsprechend vergrößert würde.

Die Detektorelemente 1, 2 und 3 des Strahlungsdetektors sind mit Vorzug zur Detektion von Strahlung in verschiedenen Wellenlängenbereichen ausgebildet. Das erste Detektorelement 1 ist etwa zur Detektion von Strahlung 71 in einem ersten Wellenlängenbereich, das zweite Detektorelement 2 zur Detektion von Strahlung 72 in einem zweiten Wellenlängenbereich und das dritte Detektorelement zur Detektion von Strahlung 73 in einem dritten Wellenlängenbereich ausgebildet.

Die Detektorelemente 1, 2 bzw. 3 weisen jeweils eine spektrale Empfindlichkeitsverteilung mit einem Maximum bei einer Maximalwellenlänge λ₁, λ₂ bzw. λ₃ auf. Die Detektorelemente sind bevorzugt derart angeordnet , dass die Maximalwellenlängen in vertikaler Richtung von der Strahlungseintrittseite 6 aus gesehen mit wachsender Entfernung der Detektorelemente von der Strahlungseintrittsseite zunehmen, d.h. λ₁ < λ₂ < λ₃ ist. Das strahlungseintrittsseitige erste Detektorelement 1 ist somit für kurzwelligere Strahlung besonders empfindlich, während das von der Strahlungseintrittseite am weitesten entfernte dritte Detektorelement 3 für längerwellige Strahlung besonders empfindlich ist. Das mittlere zweite Detektorelement 2 ist für Wellenlängen zwischen λ₁ und λ₃ besonders empfindlich.

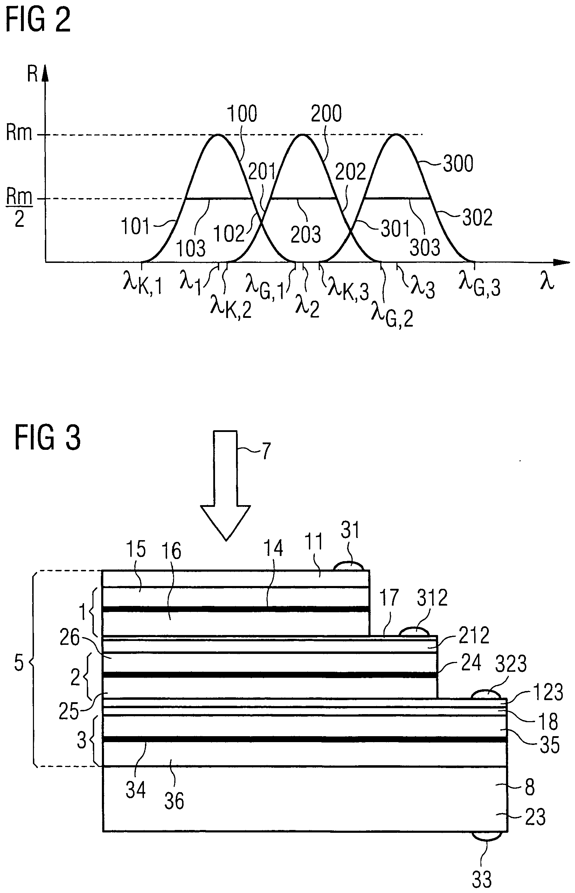

Aus den einzelnen spektralen Empfindlichkeitsverteilungen der Detektorelemente 1, 2 und 3 ergibt sich die in Figur 2 qualitativ dargestellte Empfindlichkeitsverteilung des Strahlungsdetektors. In Figur 2 ist qualitativ die Responsivität R (der im Detektorelement erzeugte Photostrom bezogen auf die auf den Strahlungsdetektor einfallende Strahlungsleistung) der Detektorelemente 1, 2 und 3 in Abhängigkeit von der Wellenlänge λ der einfallenden Strahlung dargestellt. Die spektralen Empfindlichkeitsverteilungen 100 des ersten Detektorelements 1, 200 des zweiten Detektorelements 2 und 300 des dritten Detektorelements 3 überlappen hierbei paarweise, so dass der Strahlungsdetektor über einen breiten zusammenhängenden Wellenlängenbereich empfindlich ist, wobei eine Empfindlichkeitsverteilung vorzugsweise nur mit Empfindlichkeitsverteilung(en) mit der (den) nächstliegenden Maximalwellenlänge(n) überlappt. Die Verteilungen 100 und 300 sind mit Vorzug überlappfrei.

Die einzelnen Empfindlichkeitsverteilungen weisen jeweils eine kurzwellige Grenzwellenlänge λ_{K,i} und eine langwellige Grenzwellenlänge λ_{G,i} (i = 1, 2 bzw. 3) auf, die den zusammenhängenden Empfindlichkeitsbereich des entsprechenden Detektorelements begrenzen. Um den vom Strahlungsdetektor überdeckten zusammenhängenden breiten Wellenlängenbereich, der von λ_{K,1} bis λ_{G,3} reicht, nicht unnötig zu schmälern sind die Detektorelemente zweckmäßigerweise so aufeinander abgestimmt, dass der Überlapp zwischen zwei Empfindlichkeitsverteilungen vergleichsweise gering ist. Beispielsweise sind die Detektorelemente derart aufeinander abgestimmt, dass sich zwei überlappende Empfindlichkeitsverteilungen bei einem Empfindlichkeitswert schneiden, der kleiner als der halbe Wert des Maximums bei der Maximalwellenlänge, vorzugsweise kleiner als beide halben Maximalwerte, der sich überlappenden Empfindlichkeitsverteilungen ist.

Weiterhin sind die Detektorelemente vorzugsweise derart aufeinander abgestimmt, dass sie, wie in Figur 2 gezeigt, im wesentlichen gleiche Maximalwerte R_{M} und/oder im wesentlichen gleiche spektrale Breiten (volle Breite auf halber Höhe) 103, 203 bzw. 303 aufweisen. Ferner sind die Differenzen von Maximalwellenlängen verschiedener benachbarter Empfindlichkeitsverteilungen vorzugsweise im wesentlichen gleich. Hierdurch kann insgesamt eine gleichförmige Überdeckung des Empfindlichkeitsbereichs des Strahlungsdetektors mittels der Verteilungen der einzelnen Detektorelemente erzielt werden. Außerdem wird der Vergleich in verschiedenen Detektorelementen erzeugter Signale, etwa zur Bestimmung spektraler Anteile in der Strahlung 7, vorteilhaft erleichtert.

Die Maximalwerte der spektralen Empfindlichkeitsverteilungen der Detektorelemente können relativ zueinander über geeignete Wahl der Dicken der aktiven Bereiche bzw. der Funktionsschichten im aktiven Bereich variiert werden. Je dicker der aktive Bereich ist, desto höher ist in der Regel der in diesem absorbierte Strahlungsanteil der einfallenden Strahlung und desto höher ist in der Regel die resultierende Responsivität.

Den Detektorelementen ist jeweils strahlungseintrittsseitig eine Filterschichtstruktur nachgeordnet, die wenigstens eine Filterschicht umfasst und Strahlung in einem zusammenhängenden Wellenlängenbereich absorbiert, der Wellenlängen kleiner der Maximalwellenlänge des Detektorelements umfasst. Auf diese Weise kann die kurzwellige Seite der spektralen Empfindlichkeitsverteilungen der Detektorelemente, in Figur 2 mit den Bezugszeichen 101, 201 bzw. 301 versehen, gezielt geformt werden. Insbesondere können die spektralen Breiten der Empfindlichkeitsverteilungen der Detektorelemente und/oder die Verläufe der kurzwelligen Seiten einander angeglichen werden, sodass der Vergleich in verschiedenen Detektorelementen erzeugter Signale miteinander erleichtert wird. Mit besonderem Vorteil können die Filterschichtstrukturen für die jeweiligen Detektorelemente im Halbleiterkörper monolithisch integriert sein.

Die strahlungseintrittsseitig angeordnete Kontakt- bzw. Gegenkontaktschicht des jeweiligen Detektorelements ist als Filterschicht ausgebildet. Eine einem Detektorelement zugeordnete Filterschicht ist weiterhin bevorzugt zwischen dem aktiven Bereich dieses Detektorelements und einem weiteren dem Detektorelement strahlungseintrittsseitig nachgeordneten Detektorelement angeordnet.

Die erste Kontaktschicht 11 absorbiert als Filterschicht für das erste Detektorelement 1 demnach vorzugsweise im Wellenlängenbereich kleiner λ₁, die erste Gegenkontaktschicht 212 als Filterschicht für das zweite Detektorelement 2 im Wellenlängenbereich kleiner λ₂, vorzugsweise zwischen λ₁ und λ₂, und die zweite Kontaktschicht 123 als Filterschicht für das dritte Detektorelement 3 im Wellenlängenbereich kleiner λ₃, vorzugsweise zwischen λ₂ und λ₃.

In einer weiteren bevorzugten Ausgestaltung der Erfindung umfasst der aktive Bereich wenigstens eines Detektorelements, vorzugsweise aller Detektorelemente, einen Funktionsbereich mit einer Mehrzahl von Funktionsschichten unterschiedlicher Bandlücken und/oder Dicken zur Signalerzeugung.

Über die Ausgestaltung der Funktionsschichten kann die langwellige Seite der spektralen Empfindlichkeitsverteilung des Detektorelements für Wellenlängen größer der Maximalwellenlänge gezielt geformt werden. Hierzu absorbieren die Funktionsschichten bevorzugt Strahlung in einem, insbesondere zusammenhängenden, Wellenlängenbereich, der Wellenlängen größer der Maximalwellenlänge des Detektorelements umfasst. Die Bandlücke der jeweiligen Funktionsschicht bestimmt hierbei die Wellenlänge der absorbierten Strahlung und die Dicke die absorbierte Strahlungsleistung. Die Funktionsschichten können mit Vorteil derart ausgebildet werden, dass sich das in ihnen erzeugte Signal gemäß einer vorgegebenen spektralen Empfindlichkeitsverteilung verhält. Für Wellenlängenbereiche, in denen die spektrale Empfindlichkeitsverteilung des Detektorelements gemäß der Vorgabe vergleichsweise hohe Werte annehmen soll, ist eine Funktionsschicht vergleichsweise dick ausgebildet und es wird in ihr entsprechend der absorbierten Strahlungsleistung ein vergleichsweise hohes Signal erzeugt. Eine weitere Funktionsschicht für gemäß der Vorgabe geringe Werte der spektralen Empfindlichkeitsverteilung ist vergleichsweise dünn ausgebildet und es wird in ihr nur ein dementsprechend geringeres Signal erzeugt.

Über derartige Filterschichtstrukturen und/oder Funktionsbereiche können die Empfindlichkeitsverteilungen der Detektorelemente aneinander angepasst werden. Der Vergleich von in verschiedenen Detektorelementen erzeugten Signalen kann so erleichtert werden. Über geeignete Ausbildung des Funktionsbereichs und/oder der Filterschichtstruktur kann auch gegebenenfalls eine vorteilhafte Anpassung der spektralen Breiten der einzelnen Empfindlichkeitsverteilungen aneinander erzielt werden.

In Figur 3 ist ein weiteres Ausführungsbeispiel eines erfindungsgemäßen Strahlungsdetektors anhand einer Schnittansicht schematisch dargestellt. Im wesentlichen entspricht der Strahlungsdetektor in Figur 3 dem in Figur 1 gezeigten. Im Unterschied zu Figur 1 ist auf der dem ersten Detektorelement 1 zugewandten Seite der ersten Gegenkontaktschicht 212 eine Ätzstoppschicht 17 angeordnet und eine Filterschicht 18 auf dem dritten Detektorelement angeordnet.

Die Ätzstoppschicht dient bevorzugt als Barriere oder Marker bei einem, etwa nasschemischen, Ätzprozess, über den der Halbleiterkörper von der dem Träger 8 gegenüberliegenden Seite her strukturiert werden kann. Wird der Halbleiterkörper mittels trockenchemischem Ätzen strukturiert, kann auf eine derartige Ätzstoppschicht gegebenenfalls verzichtet werden.

Weiterhin kann auch auf der zweiten Kontaktschicht 123 eine Ätzstoppschicht angeordnet sein bzw. die zweite Kontaktschicht als Ätzstoppschicht ausgebildet sein, die als Barriere für ein verglichen mit obigem Ätzmittel gleichartiges oder vom obigen verschiedenes Ätzmittel dient.

Die Filterschicht 18 ist vorzugsweise auf der der zweiten Kontaktschicht 123 zugewandten Seite, zwischen der zweiten Kontaktschicht und dem dritten Detektorelement 3, angeordnet, und absorbiert zusätzlich zur als Filterschicht ausgebildeten zweiten Kontaktschicht 123 Wellenlängen aus der durch das zweite Detektorelement und die zweite Kontaktschicht transmittierten Strahlung. Die weitere, im Halbleiterkörper integrierte Kontaktschicht 11 und/oder die Gegenkontaktschicht 212 sind weiterhin mit Vorzug ebenfalls als Filterschicht ausgebildet. Die zweite Kontaktschicht zeichnet sich mit Vorzug verglichen mit der Filterschicht durch besonders vorteilhafte Kontakteigenschaften zum Anschluss 323 aus.

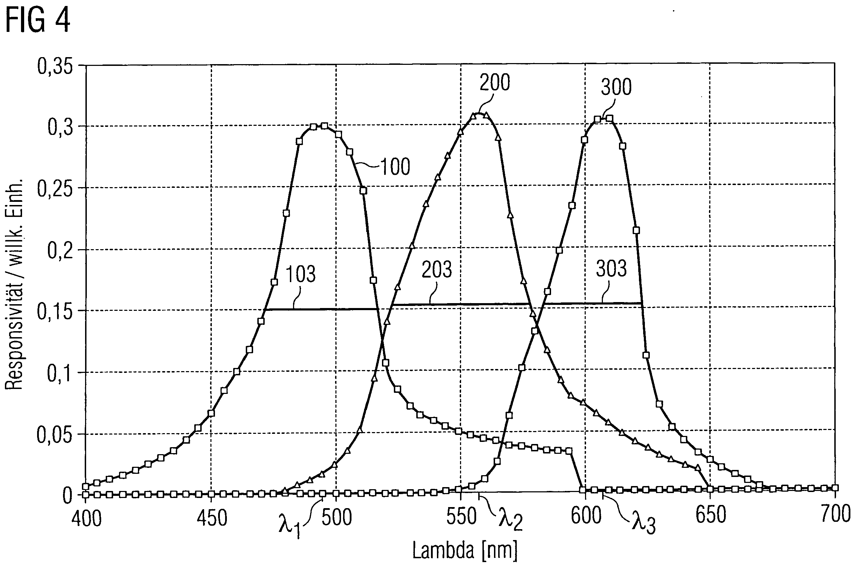

In Figur 4 ist eine Simulationsrechnung der Wellenlängenabhängigkeit der Responsivität für einen Strahlungsdetektor gemäß Figur 3, der für den sichtbaren Spektralbereich und insbesondere für verschiedenfarbige Strahlung ausgebildet ist, quantitativ gezeigt.

Der Halbleiterkörper 5 eines derartigen Strahlungsdetektors im sichtbaren Spektralbereich basiert bevorzugt auf den Materialsystemen InₓGa_{y}Al_{1-x-y}P und InₓGa_{y}Al_{1-x-y}As, die sich durch gute Epitaxieeigenschaften und vereinfacht erreichbare hohe Quanteneffizienzen im sichtbaren Spektralbereich auszeichnen. Besonders bevorzugt basiert der Halbleiterkörper auf den Materialsystemen In_{0,5}(Ga₁₋ₓAlₓ)_{0,5}P und AlₓGa₁₋ₓAs, die sich durch gute Gitteranpassung auszeichnen. Dementsprechend können qualitativ hochwertige Schichten aus diesen Materialsystemen vereinfacht epitaktisch aufeinander gewachsen werden. Die Bandlücken von Funktionsschichten im aktiven Bereich, die bevorzugt auf dem Materialsystem In_{0,5}(Ga₁₋ₓAlₓ)_{0,5}P basieren, können über den Al-Gehalt eingestellt werden.

Hierbei wurden der Simulation Daten zugrunde gelegt, die den folgenden, nacheinander, in der der Tabelle entsprechenden Reihenfolge, auf einem n-leitenden GaAs Träger 8, der das Epitaxiesubstrat bildet, epitaktisch gewachsenen Elemente des Halbleiterkörpers entsprechen. Es bezeichnet D die Dicke, E_{G} die für die Absorption maßgebliche Bandlücke und X_{G} die dieser Bandlücke entsprechende Wellenlänge.

| | Material | D [nm] ≈ | E_{G} [eV] ≈ | λ_{G} [nm] ≈ | Leitungstyp/Dotierung |
|---|---|---|---|---|---|
| Gegenbarriereschicht 36 | In_{0,5} Al_{0,5}P | 500 | 2,52 | 492 | n-leitend |
| dritter aktiver Bereich 34 | In_{0,5}(Ga_{0,8}Al_{0,2})_{0,5}P | 1000 | 2,02 | 614 | intrinsisch |
| Barriereschicht 35 | In_{0,5}Al_{0,5}P | 300 | 2,52 | 492 | p-leitend |
| Filterschicht 18 | In_{0,5} (Ga_{0,6}Al_{0,4}) _{0,5}P | 200 | 2,15 | 577 | p-leitend |
| zweite Kontaktschicht 123 | Al_{0,5}Ga_{0,5}As | 200 | 2,00 | 620 | p-leitend/ z.B. Al_{0,5} Ga_{0,5}As : C |
| Barriereschicht 25 | In_{0,5}Al_{0,5}P | 300 | 2,52 | 492 | p-leitend |
| zweiter aktiver Bereich 24 | In_{0,5} (Ga_{0,5}Al_{0,5})_{0,5}P | 1400 | 2,22 | 559 | intrinsisch |
| Gegenbarriereschicht 26 | In_{0,5}Al_{0,5}P | 300 | 2,52 | 492 | n-leitend |
| erste Gegenkontaktschicht 212 | In_{0,5} (Ga_{0,35}Al_{0,65})_{0,5}P | 150 | 2,31 | 538 | n-leitend/ z.B. In_{0,5} (Ga_{0,35}Al_{0,65})_{0,5}P : Te |
| Ätzstoppschicht 17 | Al_{0,7}Ga₀,₃AS | 50 | 2,05 | 605 | n-leitend |
| Gegenbarriereschicht 16 | In_{0,5}Al_{0,5}P | 300 | 2,52 | 492 | n-leitend |
| erster aktiver Bereich 14 | In_{0,5} (Ga_{0,2}Al₀,₈)_{0,5}P | 600 | 2,40 | 517 | Intrinsisch |
| Barriereschicht 15 | In_{0,5}Al_{0,5}P | 300 | 2,52 | 492 | p-leitend |
| erste Kontaktschicht 11 | GaP | 100 | 2,73 | 454 | p-leitend/ z.B. GaP:Mg |

Die aktiven Bereiche 14, 24 und 34 sind zur Detektion verschiedenfarbiger Strahlungen ausgebildet. Der erste aktive Bereich 14 ist für blaue, der zweite aktive Bereich 24 für grüne und der dritte aktive Bereich 34 für rote Strahlung ausgebildet. Die Maximalwellenlängen λ₁ ≈ 490 nm, λ₂ ≈ 553 nm bzw. λ₃ ≈ 615 nm der aus einer derartigen Struktur resultierenden Empfindlichkeitsverteilungen 100, 200 bzw. 300 der Detektorelemente liegen in den entsprechenden Spektralbereichen. Aufgrund der getrennten Abgreifbarkeit der Signale an verschiedenen Detektorelementen können spektrale Farbanteile, und gegebenenfalls der Farbort oder die Farbtemperatur, der auf den Strahlungsdetektor einfallenden Strahlung 7, ermittelt werden.

Die Filterschichtstruktur zur Formung der kurzwelligen Seite der Empfindlichkeitsverteilung des ersten Detektorelements umfasst hierbei die erste Kontaktschicht 11 und die Barriereschicht 15, die als Filterschichten mit geeigneten Bandlücken und Dicken ausgeführt sind. Die Filterschichtstruktur des zweiten Detektorelements umfasst die erste Gegenkontaktschicht 212 und die Filterschichtstruktur für das dritte Detektorelement im wesentlichen die Filterschicht 18. Die zweite Kontaktschicht 123 ist zur effizienten elektrischen Kontaktbildung zum zweiten und dritten Detektorelement und zugleich als Ätzstoppschicht ausgebildet. Die aktiven Bereiche 14, 24 und 34 umfassen jeweils eine einzelne Funktionsschicht.

Es sei angemerkt, dass die kurwellige Seite der Empfindlichkeitsverteilung eines beliebigen Detektorelements gegebenenfalls auch durch diesem Detektorelement strahlungseintrittsseitig nachgeordnete Strukturen, die Wellenlängen kleiner der Maximalwellenlängen des Detektorelements absorbieren, etwa einem weiteren Detektorelement und/oder der diesem zugeordneten Filterschichtstruktur beeinflusst und dementsprechend geformt wird. Eine dem beliebigen Detektorelement strahlungseintrittsseitig direkt nachgeordnete Filterschichtstruktur übernimmt jedoch mit Vorzug den Großteil der Formung der kurzwelligen Seite der Empfindlichkeitsverteilung dieses Detektorelements.

Der Strahlungsdetektor ist für Wellenlängen von ungefähr 400 nm bis ungefähr 680 nm empfindlich und überdeckt somit im wesentlichen den gesamten sichtbaren Spektralbereich, wenn man von den fernen Rotanteilen mit Wellenlängen zwischen etwa 680 nm und 700 nm absieht. Die spektralen Breiten 103, 203 bzw. 303 der Empfindlichkeitsverteilungen liegen zwischen ungefähr 40 und ungefähr 50 nm.

Der gemäß der Simulation auftretende gemeinsame Überlapp der drei Empfindlichkeitsverteilungen 100, 200 und 300 zwischen ca. 550 und 600 nm kann gegebenenfalls durch Anpassung des aktiven Bereichs der Detektorelemente und/oder der jeweiligen Filterschichtstruktur(en) noch verringert oder derart beseitigt werden, dass eine beliebige vorgegebene Empfindlichkeitsverteilung nur mit der (den) Empfindlichkeitsverteilung(en), deren Maximalwellenlänge(n) derjenigen der vorgegebenen Empfindlichkeitsverteilung unmittelbar benachbart ist (sind), überlappt.

## Patentansprüche

1. Strahlungsdetektor mit einer Mehrzahl von Detektorelementen (1,2,3), die jeweils einen zum Strahlungsempfang und zur Signalerzeugung vorgesehenen aktiven Bereich (14,24,34) aufweisen, wobei
- die Detektorelemente monolithisch in einen epitaktisch gewachsenen Halbleiterkörper (5) des Strahlungsdetektors integriert sind und vertikal zu einer lateralen Haupterstreckungsrichtung des Halbleiterkörpers übereinander im Halbleiterkörper angeordnet sind;
- der Halbleiterkörper (5) eine Strahlungseintrittsseite (6) aufweist,
- ein in einem ersten Detektorelement erzeugtes Signal getrennt von einem in einem zweiten Detektorelement erzeugten Signal abgreifbar ist,
- das erste Detektorelement für sichtbare Strahlung teilweise durchlässig ist,
- sichtbare Strahlung, die durch das erste Detektorelement hindurchtritt, in dem zweiten Detektorelement ein Signal erzeugt,
- wenigstens einem Detektorelement (1,2,3) in Richtung der Strahlungseintrittseite des Halbleiterkörpers eine monolithisch in den Halbleiterkörper integrierte Filterschichtstruktur mit mindestens einer Filterschicht nachgeordnet ist, wobei ein Wellenlängenbereich einer Absorption der Filterschicht durch eine Bandlücke der Filterschicht bestimmt ist;
- den Detektorelementen (1,2,3) jeweils eine Kontaktschicht (11, 123) und eine Gegenkontaktschicht (212,23) zugeordnet sind, zwischen denen das Detektorelement angeordnet ist, wobei über die Kontakt- und die Gegenkontaktschicht ein im aktiven Bereich des Detektorelementes erzeugtes Signal erfasst werden kann und wobei die Kontaktschicht oder die Gegenkontaktschicht zwischen dem Detektorelement und einem diesem benachbarten Detektorelement angeordnet ist, und
- die Kontaktschicht bzw. die Gegenkontaktschicht (11,123,212) wenigstens eines Detektorelements (1,2,3) zugleich als die Filterschicht der diesem Detektorelement zugeordneten Filterschichtstruktur ausgebildet ist.

2. Strahlungsdetektor nach Anspruch 1,
**dadurch gekennzeichnet, dass**
die aktiven Bereiche im Halbleiterkörper (5) benachbarter Detektorelemente voneinander beabstandet sind.

3. Strahlungsdetektor nach Anspruch 1 oder 2,
**dadurch gekennzeichnet, dass**
wenigstens ein Detektorelement (1,2,3) eine spektrale Empfindlichkeitsverteilung (100,200,300) mit einem Maximum bei einer vorgegebenen Maximalwellenlänge aufweist.

4. Strahlungsdetektor nach Anspruch 3,
**dadurch gekennzeichnet, dass**
die spektralen Empfindlichkeitsverteilungen (100,200,300) mindestens zweier Detektorelemente (1,2,3) verschiedene Maximalwellenlängen aufweisen.

5. Strahlungsdetektor nach einem der vorhergehenden Ansprüche,
**dadurch gekennzeichnet, dass**
der Strahlungsdetektor zur Detektion von Strahlung (7) in einem vorgegebenen zusammenhängenden Wellenlängenbereich ausgebildet ist.

6. Strahlungsdetektor nach einem der Ansprüche 3 bis 5,
**dadurch gekennzeichnet, dass**
die spektralen Empfindlichkeitsverteilungen (100,200,300) mindestens zweier Detektorelemente (1,2,3) überlappen.

7. Strahlungsdetektor nach einem der vorhergehenden Ansprüche,
**dadurch gekennzeichnet, dass**
wenigstens einer der aktiven Bereiche (14,24,34) eine Einfach-Quantentopfstruktur oder eine Mehrfach-Quantentopfstruktur oder eine Heterostruktur, insbesondere eine Doppelheterostruktur, aufweist.

8. Strahlungsdetektor nach einem der Ansprüche 3 bis 7,
**dadurch gekennzeichnet, dass**
die Maximalwellenlängen der spektralen Empfindlichkeitsverteilungen (100,200,300) der Detektorelemente mit wachsender Entfernung der Detektorelemente (1,2,3) von der Strahlungseintrittsseite (6) der vom Strahlungsdetektor zu empfangenden Strahlung in den Halbleiterkörper (5) zunehmen.

9. Strahlungsdetektor nach einem der vorhergehenden Ansprüche,
**dadurch gekennzeichnet, dass**
die Filterschichtstruktur zur Absorption von Wellenlängen in einem Wellenlängenbereich ausgebildet ist, der Wellenlängen kleiner der Maximalwellenlänge der spektralen Empfindlichkeitsverteilung des Detektorelements umfasst.

10. Strahlungsdetektor nach einem der vorhergehenden Ansprüche,
**dadurch gekennzeichnet, dass**
zwei benachbarte Detektorelemente (1,2,3) eine gemeinsame Kontaktschicht (123) bzw. eine gemeinsame Gegenkontaktschicht (212) aufweisen.

11. Strahlungsdetektor nach einem der vorhergehenden Ansprüche,
**dadurch gekennzeichnet, dass**
der Halbleiterkörper (5), insbesondere der aktive Bereich (14,24,34) und/oder die Filterschichtstruktur wenigstens eines Detektorelements (1,2,3), mindestens ein III-V-Halbleitermaterial enthält.

12. Strahlungsdetektor nach Anspruch 11,
**dadurch gekennzeichnet, dass**
das III-V-Halbleitermaterial ein Material aus den Materialsystemen InₓGa_{y}Al_{1-x-y}P, InₓGa_{y}Al_{1-x-y}As oder InₓGa_{y}Al_{1-x-y}N, jeweils mit 0≤x≤1, 0≤y≤1 und x+y≤1, ist.

13. Strahlungsdetektor nach Anspruch 12,
**dadurch gekennzeichnet, dass**
die aktiven Bereiche auf dem Materialsystem InₓGa_{y}Al_{1-x-y}P basieren.

14. Strahlungsdetektor nach Anspruch 13,
**dadurch gekennzeichnet, dass**
für die Filterschichtstruktur ein Material aus dem Untermaterialsystem AlₓGa₁₋ₓAs und für die auf dem Materialsystem InₓGa_{y}Al_{1-x-y}P basierenden Schichten Materialien aus dem Untermaterialsystem In_{0,5}(Ga₁₋ₓAlₓ)_{0,5}P gewählt sind.

15. Strahlungsdetektor nach einem der vorhergehenden Ansprüche,
**dadurch gekennzeichnet, dass**
der Halbleiterkörper epitaktisch auf einem Epitaxiesubstrat gewachsen ist.

16. Strahlungsdetektor nach einem der vorhergehenden Ansprüche,
**dadurch gekennzeichnet, dass**
die Detektorelemente (1,2,3) zur Detektion verschiedenfarbiger Strahlungen ausgebildet sind.

17. Strahlungsdetektor nach einem der vorhergehenden Ansprüche,
**dadurch gekennzeichnet, dass**
der Strahlungsdetektor drei Detektorelemente (1,2,3) umfasst, die zur Detektion von Strahlung im blauen, grünen bzw. roten Spektralbereich ausgebildet sind.

18. Strahlungsdetektor nach einem der vorhergehenden Ansprüche,
**dadurch gekennzeichnet, dass**
der Strahlungsdetektor zur Bestimmung von spektralen Farbanteilen in der vom Strahlungsdetektor zu empfangenden Strahlung (7) ausgebildet ist.

19. Strahlungsdetektor nach einem der vorhergehenden Ansprüche,
**dadurch gekennzeichnet, dass**
der Strahlungsdetektor zur Bestimmung des Farbeindrucks von auf den Detektor einfallender Strahlung (7) ausgebildet ist.

## Claims

1. A radiation detector comprising a plurality of detector elements (1, 2, 3) each having an active region (14, 24, 34) provided for radiation reception and for signal generation, wherein
- the detector elements are monolithically integrated into an epitaxially grown semiconductor body (5) of the radiation detector and are arranged one above the over in the semiconductor body in a direction extending vertically to a lateral main direction of extent;
- the semiconductor body (5) has a radiation entry side (6);
- a signal generated in a first detector element can be tapped off separately from a signal generated in a second detector element;
- the first detector element is partly transmissive to visible radiation; and
- visible radiation that passes through the first detector element generates a signal in the second detector element;
- a filter layer structure, which is monolithically integrated in the semiconductor body, with at least one filter layer is arranged downstream of at least one detector element (1, 2, 3) in the direction of the radiation entry side of the semiconductor body, wherein a wavelength region of absorption of the filter layer is determined by a band gap of the filter layer;
- in each case a contact layer (11, 123) and a counter-contact layer (212, 23), between which the detector element is arranged, is assigned to the detector element, wherein via the contact layer and the counter- contact layer a signal generated in the active region of the detector element can be received and wherein the contact layer or the counter-contact layer are arranged between the detector element and a detector element adjacent thereto, and
- the contact layer or the counter-contact layer (11, 123, 212) of at least one detector element (1, 2, 3) is simultaneously configured as the filter layer of the filter layer structure assigned to this detector element.

2. The radiation detector as claimed in claim 1,
**characterized in that**
the active regions in the semiconductor body (5) of adjacent detector elements are spaced apart from one another.

3. The radiation detector as claimed in claim 1 or 2,
**characterized in that**
at least one detector element (1, 2, 3) has a spectral sensitivity distribution (100, 200, 300) with a maximum at a predetermined maximum wavelength.

4. The radiation detector as claimed in claim 3,
**characterized in that**
the spectral sensitivity distributions (100, 200, 300) of at least two detector elements (1, 2, 3) have different maximum wavelengths.

5. The radiation detector as claimed in one of the preceding claims,
**characterized in that**
the radiation detector is designed for detecting radiation (7) in a predetermined continuous wavelength range.

6. The radiation detector as claimed in one of claims 3 to 5,
**characterized in that**
the spectral sensitivity distributions (100, 200, 300) of at least two detector elements (1, 2, 3) overlap.

7. The radiation detector as claimed in one of the preceding claims,
**characterized in that**
at least one of the active regions (14, 24, 34) has a single quantum well structure or a multiple quantum well structure or a heterostructure, in particular a double heterostructure.

8. The radiation detector as claimed in one of claims 3 to 7,
**characterized in that**
the maximum wavelengths of the spectral sensitivity distributions (100, 200, 300) of the detector elements increase with increasing distance between the detector elements (1, 2, 3) and the radiation entry side (6) of the radiation to be received by the radiation detector into the semiconductor body (5).

9. The radiation detector as claimed in one of the preceding claims,
**characterized in that**
the filter layer structure is designed for absorbing wavelengths in a wavelength range comprising wavelengths less than the maximum wavelength of the spectral sensitivity distribution of the detector element.

10. The radiation detector as claimed in claim 11 or 12,
**characterized in that**
two adjacent detector elements (1, 2, 3) have a common contact layer (123) or a common counter-contact layer (212).

11. The radiation detector as claimed in one of the preceding claims,
**characterized in that**
the semiconductor body (5), in particular the active region (14, 24, 34) and/or the filter layer structure of at least one detector element (1, 2, 3), contains at least one III-V semiconductor material.

12. The radiation detector as claimed in claim 11,
**characterized in that**
the III-V semiconductor material is a material from the material systems InₓGa_{y}Al_{1-x-y}P, InₓGa_{y}Al_{1-x-y}As or InₓGa_{y}Al_{1-x-y}N, in each case where 0≤x≤1, 0≤y≤1 and x+y≤1.

13. The radiation detector as claimed in claim 12,
**characterized in that**
the active regions are based on the material system InₓGa_{y}Al_{1-x-y}P.

14. The radiation detector as claimed in claim 13,
**characterized in that**
for the filter layer structure a material from the submaterial system AlₓGa₁₋ₓAs and for the layers based on the material system InₓGa_{y}Al_{1-x-y}P materials from the submaterial system In_{0,5}(Ga₁₋ₓAlₓ)₀,₅P are selected.

15. The radiation detector as claimed in one of the preceding claims,
**characterized in that**
the semiconductor body is epitaxially grown on an epitaxy substrate.

16. The radiation detector as claimed in one of the preceding claims,
**characterized in that**
the detector elements (1, 2, 3) are designed for detecting varicolored radiations.

17. The radiation detector as claimed in one of the preceding claims,
**characterized in that**
the radiation detector comprises three detector elements (1, 2, 3) which are designed for detecting radiation in the blue, green and red spectral range, respectively.

18. The radiation detector as claimed in one of the preceding claims,
**characterized in that**
the radiation detector is designed for determining spectral color components in the radiation (7) to be received by the radiation detector.

19. The radiation detector as claimed in one of the preceding claims,
**characterized in that**
the radiation detector is designed for determining the color impression of radiation (7) incident on the detector.

## Revendications

1. Détecteur de rayonnement avec une pluralité d'éléments de détecteurs (1, 2, 3), qui présentent respectivement une région active (14, 24, 34) prévue en vue de la réception de rayonnement et de la génération de signaux, sachant que
- les éléments de détecteurs sont intégrés monolithiquement dans un corps de semiconducteur formé par croissance épitaxiale (5) du détecteur de rayonnement et qui sont disposés verticalement par rapport à une direction de projection principale latérale du corps de semi-conducteur les uns au-dessus des autres dans le corps de semi-conducteur ;
- le corps de semi-conducteur (5) présente un côté d'entrée de rayonnement (6),
- un signal généré dans un premier élément de détecteur est prélevable séparément d'un signal généré dans un second élément de détecteur,
- le premier élément de détecteur est partiellement perméable pour le rayonnement visible,
- le rayonnement visible qui pénètre à travers le premier élément de détecteur génère un signal dans le second élément de détecteur,
- au moins en aval d'un élément de détecteur (1, 2, 3) dans la direction du côté d'entrée de rayonnement du corps de semi-conducteur est placée une structure de couches filtrantes intégrée monolithiquement dans le corps de semi-conducteur avec au moins une couche filtrante, sachant qu'une plage de longueur d'ondes d'une absorption de la couche filtrante est déterminée par un écart énergétique de la couche filtrante ;
- aux éléments de détecteurs (1, 2, 3) sont affectés respectivement une couche de contact (11, 123) et une couche de contact opposé (212, 23) entre lesquelles l'élément de détecteur est disposé, sachant que via les couches de contact et de contact opposé, un signal généré dans la région active de l'élément de détecteur peut être saisi et sachant que la couche de contact ou la couche de contact opposé sont disposées entre l'élément de détecteur et un élément de détecteur voisin de celui-ci, et
- la couche de contact et/ou la couche de contact opposé (11, 123, 212) d'au moins un élément de détecteur (1, 2, 3) est constituée en même temps comme la couche filtrante de la structure de couches filtrantes affectée à cet élément de détecteur.

2. Détecteur de rayonnement selon la revendication 1,
**caractérisé en ce que**
les régions actives dans le corps de semi-conducteur (5) des éléments de détecteurs avoisinants sont espacées les unes des autres.

3. Détecteur de rayonnement selon les revendications 1 ou 2,
**caractérisé en ce que**
au moins un élément de détecteur (1, 2, 3) présente une répartition de sensibilité spectrale (100, 200, 300) avec un maximum à une longueur d'onde maximale prescrite.

4. Détecteur de rayonnement selon la revendication 3,
**caractérisé en ce que**
les répartitions de sensibilité spectrales (100, 200, 300) présentent au moins des longueurs d'ondes maximales différentes de deux éléments de détecteurs (1, 2, 3).

5. Détecteur de rayonnement selon une quelconque des revendications précédentes,
**caractérisé en ce que**
le détecteur de rayonnement est constitué en vue de la détection de rayonnement (7) dans une plage de longueur d'ondes cohérente prescrite.

6. Détecteur de rayonnement selon une quelconque des revendications 3 à 5,
**caractérisé en ce que**
les répartitions de sensibilité spectrales (100, 200, 300) d'au moins deux éléments de détecteurs (1, 2, 3) se chevauchent.

7. Détecteur de rayonnement selon une quelconque des revendications précédentes,
**caractérisé en ce que**
au moins une des régions actives (14, 24, 34) présente une structure de puits quantique simple ou une structure de puits quantique multiple ou une hétérostructure, notamment une hétérostructure double.

8. Détecteur de rayonnement selon une quelconque des revendications 3 à 7,
**caractérisé en ce que**
les longueurs d'ondes maximales des répartitions de sensibilité spectrales (100, 200, 300) des éléments de détecteurs augmentent avec une distance croissante des éléments de détecteurs (1, 2, 3) à partir du côté d'entrée de rayonnement (6) du rayonnement à recevoir par le détecteur de rayonnement dans le corps de semi-conducteur (5).

9. Détecteur de rayonnement selon une quelconque des revendications précédentes,
**caractérisé en ce que**
la structure de couches filtrantes est constituée en vue de l'absorption de longueurs d'ondes dans une plage de longueur d'ondes, qui comprend des longueurs d'ondes inférieures aux longueurs d'ondes maximales de la répartition de sensibilité spectrale de l'élément de détecteur.

10. Détecteur de rayonnement selon une quelconque des revendications précédentes,
**caractérisé en ce que**
deux éléments de détecteurs voisins (1, 2, 3) présentent une couche de contact commune (123) et/ou une couche commune de contact opposé (212).

11. Détecteur de rayonnement selon une quelconque des revendications précédentes,
**caractérisé en ce que**
le corps de semi-conducteur (5), notamment la région active (14, 24, 34) et/ou la structure de couches filtrantes d'au moins un élément de détecteur (1, 2, 3) contient au moins un matériau de semi-conducteur III-V.

12. Détecteur de rayonnement selon la revendication 11,
**caractérisé en ce que**
le matériau de semi-conducteur III-V est un matériau issu des systèmes de matériaux InₓGa_{y}Al_{1-x-y}P, InₓGa_{y}Al_{1-x-y}As ou InₓGa_{y}Al_{1-x-y}N, respectivement avec 0≤x≤1, 0≤y≤1 et x+y≤1.

13. Détecteur de rayonnement selon la revendication 12,
**caractérisé en ce que**
les régions actives se basent sur le système de matériaux InₓGa_{y}Al_{1-x-y}P.

14. Détecteur de rayonnement selon la revendication 13,
**caractérisé en ce que**
pour la structure de couches filtrantes sont sélectionnés un matériau issu du système de sous-matériaux AlₓGa₁₋ₓAs et pour les couches se basant sur le système de matériaux InₓGa_{y}Al_{1-x-y}P, des matériaux issu du système de sous-matériaux In_{0,5}(Ga₁₋ₓAlₓ)_{0,5}P.

15. Détecteur de rayonnement selon une quelconque des revendications précédentes,
**caractérisé en ce que**
le corps de semi-conducteur a poussé épitaxialement sur un substrat d'épitaxie.

16. Détecteur de rayonnement selon une quelconque des revendications précédentes,
**caractérisé en ce que**
les éléments de détecteurs (1, 2, 3) sont configurés pour la détection de rayonnements de couleurs différentes.

17. Détecteur de rayonnement selon une quelconque des revendications précédentes,
**caractérisé en ce que**
le détecteur de rayonnement comporte trois éléments de détecteurs (1, 2, 3) qui sont constitués dans la région spectrale bleue, verte ou rouge en vue de la détection de rayonnement.

18. Détecteur de rayonnement selon une quelconque des revendications précédentes,
**caractérisé en ce que**
le détecteur de rayonnement est constitué pour la détermination de composantes chromatiques spectrales dans le rayonnement (7) à recevoir par le détecteur de rayonnement.

19. Détecteur de rayonnement selon une quelconque des revendications précédentes,
**caractérisé en ce que**
le détecteur de rayonnement est constitué pour la détermination de l'effet de couleur du rayonnement (7) incident sur le détecteur.
